# EUROPEAN PATENT SPECIFICATION

(11) **EP 0 407 086 B1**
(45) Date of publication and mention of the grant of the patent: **26.02.1997**
(21) Application number: 90307008.4
(22) Date of filing: 27.06.1990
(51) Int. Cl.: G03F 7/038, G03F 7/004

(54) **Melamine-containing photoresists of improved sensitivity**
Melamin enthaltende Fotowiderstände mit hoher Empfindlichkeit
Photoréserves à base de mélamine présentant une plus grande sensibilité

(30) Priority: 07.07.1989 US 376713
(43) Date of publication of application: 09.01.1991
(73) Proprietor: ROHM AND HAAS COMPANY, Philadelphia Pennsylvania 19105 (US)
(72) Inventor: Graziano, Karen Ann, Warrington, Pennsylvania 18976 (US); Bogan, Leonard Edward, Jr., Haleyville, Pennsylvania 19438 (US); Olsen, Robert James, Lansdale, Pennsylvania 19446 (US); Anderson McIlnay, Susan Elizabeth, Exton, Pennsylvania 19341 (US)
(74) Representative: Tanner, James Percival

(56) References cited:
- EP-A- 0 133 216
- EP-A- 0 232 972
- EP-A- 0 256 981
- US-A- 4 341 859

## Description

The present invention is concerned with improved melamine-containing photoresists.

Acid-hardening photoresist compositions that contain melamine resin as a crosslinker have been disclosed, for example in EP-A-0164248, EP-A-0232973, and EP-A-0232972. These patent applications disclose photoresists containing acid-hardening resin which may contain an aminoplast such as melamine resin as a crosslinker, along with resins such as novolac or polyvinylphenol, and a photoacid generator. The photoacid generator produces acid in response to exposure to the activating wavelength. The acid initiates the reaction between the components of the acid-hardening resin. The melamine resins that are disclosed to be useful in these applications include Cymel 303, a commercially available melamine resin that contains hexamethoxymethylmelamine resin monomer as well as dimers and trimers of the monomer.

Photoresists containing hexamethoxymethylmelamine are also disclosed in EP-A-0 133 216 and EP-A-0 256 981.

Hexamethoxymethylmelamine, (HMMM), has been used in coating compositions and is commercially supplied, for example by American Cyanamid Company which markets products of various purity under the tradename Cymel, such as Cymel 303, Cymel 300, etc.. The art contains disclosures of experiments that are said to be run using hexamethoxymethylmelamine when the reagent was a commercial resin such as Cymel. Commercially supplied melamine resin materials such as the Cymel resins contain significant quantities of impurities, such as dimers, trimers, tetramers, and contaminants. Gel Permeation Chromatography of samples of Cymel 300, a high purity version of hexamethoxymethylmelamine, revealed: a monomer content of 74 to 79 percent by weight; a dimer content of from 16 to 19 percent; and a trimer content of from 4 to7 percent by weight.

Lithographic potential is a measure of the expected lithographic performance of a photoresist composition. Lithographic potential is expressed as a numeric value, equal to the log₁₀ of the result of dividing the dissolution rate of the unexposed areas of the resist by the dissolution rate of the exposed areas of the resist. The lithographic potential is an expression of the observed degree of reaction in the exposed areas in response to the dose at a particular wavelength of the exposing radiation. A lowered dissolution rate indicates increased resistance of the resin to removal by the developer solution, and therefore serves as a measure of the degree of chemical reaction in response to the exposing radiation. The sensitivity of various resists can be compared by measuring their lithographic potentials. A resist that requires a lower dose at the exposing wavelength to produce a lithographic potential of a given value can be said to be more sensitive than a resist that requires a higher dose to produce a lithographic potential of the same value.

According to the present invention there is provided an improved photoresist, which comprises:-
(i) acid-hardening resin system comprising:
   (a) melamine resin having a hexamethoxymethylmelamine monomer content of greater than 83 percent by weight, based on the weight of the melamine resin; and
   (b) reactive hydrogen-containing compound; and
(ii) photoacid generator.

The present invention provides photoresists of improved sensitivity and shelf-life wherein the melamine resin contains an increased amount of hexamethoxymethylmelamine monomer by weight . The monomer content is greater than 83%, usually greater than 87%, and preferably greater than 89% by weight.

For example, melamine resins containing hexamethoxymethylmelamine may be purified to remove synthesis by-products and contaminants. Preferably, the melamine resin is distilled hexamethoxymethylmelamine resin monomer.

In one embodiment of the present invention, there is provided a photoresist of improved shelf-life wherein synthesis by-products and impurities, for example water, in the melamine resin that promote self-condensation of the hexamethoxymethylmelamine monomer have been removed to an extent sufficient to reduce the degree of oligomerization during storage of the liquid resist, for example, wherein water has been removed to a level of less than 25,000 ppm, preferably less than 10,000 ppm, based on the photoresists.

The resists according to the present invention display improved sensitivity over previously known resists that contain melamine resin as the crosslinker. Applicants have found a pronounced increase in the sensitivity of photoresists when the melamine resin component of the resist contains a high percentage of monomeric hexamethoxymethylmelamine .

The structural formula for monomeric hexamethoxymethylmelamine is:

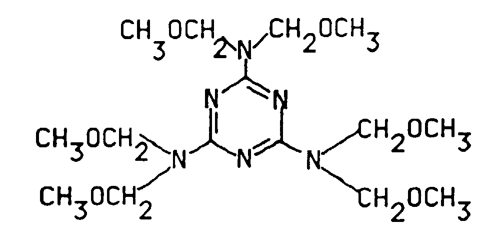

Significant proportions of dimers and trimers of hexamethoxymethylmelamine are produced as synthesis by-products or through an acid-catalyzed condensation reaction and are present in commercial products.

We have found that photoresists that contain melamine resin crosslinker of high monomeric hexamethoxymethylmelamine content have improved sensitivity, as measured by lithographic potential, when compared to known melamine resin-containing photoresists. The photoresists according to the invention usually contain melamine resin having greater than 87 percent monomeric hexamethoxymethylmelamine resin by weight. The preferred amount of monomeric hexamethoxymethylmelamine is from about 89 to about 100 percent, based on the total weight of the melamine resin.

The photoresists of the invention comprise: (i) acid-hardening resin system comprising the melamine resin and reactive hydrogen containing compound, the latter reacting with the melamine resin in an acid-catalyzed reaction; and (ii) photoacid generator which is a compound that generates or releases acid in response to the wavelength of the exposing radiation. Suitable resins and photoacid generators include those described in EP-A-0404499 and EP-A-0232972.

As indicated above, the melamine resins are used in combination with reactive hydrogen-containing compounds in the acid-hardening resin system. These reactive hydrogen-containing compounds include: novolac resins; polyvinylphenols; copolymers of these with styrene, α-methylstyrene, acrylic resins, etc.; polyglutarimides; polyacrylic acid and polymethacrylic acid copolymers; alkali-soluble polyacrylamides and polymethacrylamide copolymers; copolymers containing 2-hydroxyethyl(meth)acrylate and/or 2-hydroxypropyl(meth)acrylate; polyvinyl alcohols such as those prepared from partially hydrolyzed polyvinyl acetates; alkali-soluble styrene-allyl alcohol copolymers; and mixtures thereof. Novolac resins containing hydroxyl groups and sites for the electrophilic substitution of aromatic rings at positions ortho or para relative to the hydroxyl group are preferred. Novolac resins that are useful in conjunction with melamine resins in the acid-hardening resin system are alkali-soluble film forming phenolic resins having a molecular weight (weight average) ranging from about 300 to about 100,000, and preferably from about 1,000 to 20,000. These novolac resins may be prepared by the condensation reaction of a phenol, a naphthol or a substituted phenol, such as cresol, xylenol, ethylphenol, butylphenol, isopropyl methoxyphenol, chlorophenol, bromophenol, resorcinol, naphthol, chloronaphthol, bromonaphthol or hydroquinone with formaldehyde, acetaldehyde, benzaldehyde, furfural, acrolein or the like. Blends of suitable novolac resins may also be used in order to adjust the dissolution rate of the exposed coating in aqueous base solutions as well as for adjusting the viscosity, hardness and other physical properties of the coating. Suitable novolac resins are disclosed in numerous patents including US-A-3148983; US-A-4404357, US-A-4115128, US-A-4377631, US-A-4423138, and US-A-4424315, the disclosures of which are incorporated by reference herein.

Melamine resins may also be used in conjunction with polyglutarimides, prepared according to US-A-4246374 having a weight average molecular weight ranging from about 1,000 to about 100,000, which are soluble in aqueous base and contain at least 40 weight percent of the nitrogen atoms in the NH or ammonia form. When polyglutarimides are used in conjunction with melamine resins, the melamine resin is present at a concentration of from about 20 to about 80 percent by weight, based on the weight of the polyglutarimide.

Alkali soluble polyvinylphenols having a weight average molecular weight ranging from about 2,000 to about 100,000 can also be employed with melamine resins to form useful acid-hardening resin systems. These coatings yield thermally stable images capable of withstanding heating for about 30 minutes at temperatures ranging from about 400 to about 500°C.

An alkali-soluble (meth)acrylic acid-styrene copolymer containing at least 15 weight percent, and preferably 30 weight percent, (meth)acrylic acid and having a weight average molecular weight of about 12,000 can also be used in combination with melamine resins to form an acid-hardening resin system useful in the practice of the invention.

Suitable photoacid generators include those disclosed in our EP-A-0232972. These photoacid generators include: 1,1-bis[p-chlorophenyl]-2,2,2-trichloroethane (DDT); 1,1-bis[p-methoxyphenyl]-2,2,2-trichloroethane(Methoxychlor); 1,2,5,6,9,10-hexabromocyclododecane; 1,10-dibromodecane; 1,1-bis[p-chlorophenyl]-2,2-dichloroethane; 4,4'-dichloro-2-(trichloromethyl)benzhydrol or 1,1-bis(chlorophenyl)-2,2,2-trichloroethanol (Kelthane); hexachlorodimethylsulfone; 2-chloro-6-(trichloromethyl)pyridine; 0.0-diethyl-0-(3,5,6-trichloro-2-pyridyl)phosphorothioate (Dursban); 1,2,3,4,5,6-hexachlorocyclohexane; N(1,1-bis[p-chlorophenyl]-2,2,2-trichloroethylacetamide, tris[2,3-dibromopropyl]isocyanurate; and 2,2-bis[p-chlorophenyl]-1,1-dichloroethylene.

Preferred deep UV photoacid generators are: DDT, Methoxychlor, Kelthane, tris(2,3-dibromopropyl)-isocyanurate, and 2,2,2-tribromoethanol.

Other photoacid generators, that are useful in the near UV and can be used with acid-hardening resins, include dichloroacetophenone derivatives, substituted and unsubstituted N-methylquinolinium salts, for example paratoluene sulfonate, and N-alkoxypyridinium salts such as are described in US-A-2971002.

The photoresist may be formulated by admixing photoacid generator with the acid-hardening resin in solvent. The mixture is stirred until a homogeneous solution is obtained.

Suitable solvent systems include typically non-reacting solvents which have been found to be useful with the acid-hardening resins and photoacid generators and include: glycol ethers, such as ethylene glycol monomethyl ether, ethylene glycol monoethyl ether, ethylene glycol dimethylether, Proposol B and P and the like; Cellosolve esters, such as methyl Cellosolve acetate, ethyl Cellosolve acetate and the acetates of Proposol B and P, and the like; aromatic hydrocarbons, such as toluene, xylene and the like; ketones, such as acetone, methylethylketone, cyclopentanone, cyclohexanone and the like; esters, such as ethylacetate, butyl acetate, isobutyl isobutyrate, butyrolactone and the like; amides, such as a dimethyl acetamide (DMAC), N-methyl pyrrolidone NMP), dimethyl formamide (DMF) and the like; chlorinated hydrocarbons, such as methylene chloride, ethylene dichloride, 1,1,1-trichloroethane, chlorobenzene, ortho-dichlorobenzene and the like; nitrobenzene; dimethylsulfoxide; and mixtures of the above. Mixtures of these compounds, optionally containing minor amounts of other suitable compounds, are also useful as solvents. The photosensitive coating solution may contain at least 50 percent by weight solvent, and preferably from about 65 to 95 percent by weight solvent. The solvent system used must not react adversely with the other components in the photoresist and coatings formed using the photoresists must be of a homogeneous nature, free from sediment, crystallized components, particulates and dirt.

The use of high hexamethoxymethylmelamine monomer content resin to improve the sensitivity of other melamine resin-containing photoresists is also contemplated as within this invention. The use of additional resins along with the hexamethoxymethylmelamine as the components of an acid-hardening resin system, or different photosensitizers to initiate the hardening reaction between the melamine resin and the other resin, should not be construed to bring a photoresist outside the scope of this invention.

The preparation of hexamethoxmethylmelamine is well known and is described for example in U.S.-A-3,322,762, and US-A-3,488,350. Melamine resins that contain hexamethoxymethylmelamine are commercially available, for example from American Cyanamid Company under the tradename Cymel. High purity monomer can be recovered from the commercially available materials, for example by batch distillation. Purification by distillation removes by-products of synthesis such as oligomers and incompletely substituted compounds, such as those containing free methylol groups.

Distillation also removes contaminants such as metal catalyst residues and water. Resists that contain purified hexamethoxymethylmelamine have been observed to have improved shelf-life versus resists that contain commercially available melantine resin. The improved shelf-life of resists that contain purified hexamethoxymethylmelamine is believed to be a result of removal of impurities that cause the hexamethoxymethylmelamine to self-condense. A component study indicates that the shelf-life problem can be experimentally caused to occur in a sample of purified hexamethoxymethylmelamine resin by reintroducing water into the purified sample and then storing in the presence of novolac.

The present invention will now be further illustrated by way of the following Examples which are for illustrative purposes only and are not to be construed as imposing any limitation on the scope of the Claims. Unless specifically stated otherwise, all percentages recited in the present specification are percentages by weight.

### Examples

Unless otherwise stated: the resist solutions were spin-coated onto wafers at 3000 revolutions per minute; the coated wafers were prebaked on a hotplate at 80°C for one minute; post baked on a hotplate at 115°C for one minute and developed using 0.27N Shipley MF-322 tetramethylammonium hydroxide.

### Example 1 - Preparation of Purified Hexamethoxymethylmelamine

Cymel 300 melamine resin (American Cyanamid Company) was purified through a simple vacuum distillation using a 15.24 cms (6 inch) Vigreux column, maintaining the head temperature at 249 to 253°C and using a steam condenser to collect the efflux. The product was analyzed by Gel Permeation Chromatography and contained 99% hexamethoxymethylmelamine.

### Example 2 - Comparison of Purified Hexamethoxymethylmelamine Resist to a known Acid-Hardening Resist

Two resist solutions were prepared according to the following formulation:
60 grams of cresol novolac; 273 grams of Microposit Thinner Type A, cellosolve acetate, (Shipley Company); 1.73 grams of tris(2,3-dibromopropyl)isocyanurate; and 9 grams of melamine resin. In the first resist, Comparison A, the melamine resin was Cymel 303. In the second resist, Example 2, the melamine resin was a distilled sample of hexamethoxymethylmelamine containing greater than 99% monomer by weight. On day 0, samples of these resists were coated on wafers, exposed at 254 nanometers and developed using a Development Rate Monitor. Other samples of the two resists were heat aged at 50°C for periods of 4,7 and 14 days and at the end of the interval, the samples were coated onto wafers, exposed and developed using a Development Rate Monitor.

The Example 2 resist showed surprisingly increased sensitivity over that of the Comparison A resist on day 0 and the Example 2 resist showed little decrease in sensitivity after 4,7 and 14 days of heat aging. The Comparison A resist showed poorer sensitivity on day 0 and its sensitivity degraded further during the storage test.

### Example 3 -

Resists were prepared using the same proportions of novolac, photoacid generator and melamine resin, changing only the composition of the melamine resin. A standard solution was prepared by mixing: 103.18 grams of a solution of cresol novolac (30% solids) in cellosolve acetate solvent; 68.78 grams of added cellosolve acetate solvent; and 0.923 grams of tris(2,3- dibromopropyl)isocyanurate photoacid generator. Test samples were prepared by taking 25 gram aliquots from the standard solution and adding 0.655 grams of melamine resin to the aliquot. The melamine resin used in the various samples was prepared using a sample of Cymel 300 resin that contained 75% monomer by weight, a sample of distilled hexamethoxymethylmelamine that contained greater than 99% monomer by weight, and blends of these two materials. In a preliminary test the monomer content in the melamine resins was varied in five resist samples prepared using Cymel 300, distilled hexamethoxymethylmelamine and blends of these two resins at proportions of 25/75,50/50, and 75/25 to produce resists that contained melamine resin having approximately 75,81.25,87.5,93.75 and 100 percent hexamethoxymethylmelamine monomer by weight.

These resists were coated on wafers, exposed and developed using a Development Rate Monitor to measure lithographic potential. The results indicated significant improvement in sensitivity for the resists prepared using melamine resin having hexamethoxymethylmelamine content of 87.5 weight percent and greater. A second set of resists that contained melamine resin having hexamethoxyinethylmelamine content of 83,85,87,89 and 92 weight percent were prepared and processed as above and the results of both sets of experiments are presented in Table 1 below:

**TABLE 1**

| Sample No. | Monomer Content of the melamine resin (% by weight) | Lithographic Potential at dose of 0.234mJ/cm² |
|---|---|---|
| 1 | 75.0 | 0.20 |
| 2 | 81.25 | 0.20 |
| 3 | 83.0 | 0.25 |
| 4 | 85.0 | 0.26 |
| 5 | 87.0 | 0.26 |
| 6 | 87.5 | 0.28 |
| 7. | 89.0 | 0.29 |
| 8. | 92 | 0.36 |
| 9. | 93.75 | 0.43 |
| 10. | 100 | 0.80 |

The data shows that the performance of the otherwise identical resist materials surprisingly improved when the hexamethoxymethylmelamine monomer content of the melamine resin was increased to about 83% and the sensitivity increased more rapidly as the hexamethoxymethylmelamine monomer content of the melamine resin was raised from greater than about 87%, preferably greater than about 89%, by weight, to about 100% hexamethoxymethylmelamine monomer content by weight.

### Example 4 -

Two solutions were prepared according to the following formulation: 51.59 grams of a solution of cresol novolac (30% solids) in cellosolve acetate; 34.39 grams of added cellosolve acetate; and 2.33 grams of melamine resin. In the first solution, Comparative B, the melamine resin was Cymel 303 (American Cyanamid). In the second solution, Example 4, the melamine resin was purified hexamethoxymethylmelamine (∼100% monomer). Experimental samples were prepared by taking 15 gram aliquots from one of these two solutions and adding 0.039 grams of 1,1-bis(p-chlorophenyl)-1-chloro-2,2,2-trichloroethane as photoacid generator. The resists were coated onto wafers, exposed to a dose of 1mJ/cm² at 254 nanometers and developed using a Development Rate Monitor. The data demonstrated greater than about a two-fold increase in lithographic potential for the Example 4 resist containing purified hexamethoxymethylmelamine compared against the known Cymel-containing Comparative B resist.

### Example 5 - Distilled Hexamethoxymethylmelamine in Polyvinylphenol Resist

A resist was prepared by mixing: 203.5 grams of a 30% solution of polyvinylphenol in bis-(2-methoxyethyl) ether ( "diglyme"); 6 grams of distilled hexamethoxymethylmelamine (∼99% monomer); 1.75 grams of tris(2,3- dibromopropyl)isocyanurate; and 135.6 grams of diglyme. The resist was spin-coated onto wafers at 4000 rpm, prebaked at 80°C for one minute, then exposed at 254 nanometers using an HTG exposure tool. The exposed resist was post-baked for one minute at 115°C and developed with 0.12 N tetramethylammonium hydroxide using a Development Rate Monitor to generate a lithographic potential curve which demonstrated excellent sensitivity of the resist.

### Example 6 - Distilled Hexamethoxymethylmelamine in E-beam Resist

A resist was prepared by mixing 16.5 grams of meta-cresol novolac resin,
1.9 grams of tris(2,3-dibromopropyl)isocyanurate, 2.47 grams of distilled hexamethoxymethylmelamine (99% monomer) and 75 grams of Microposit Thinner Type A, cellosolve acetate, (Shipley Company). The resist was spin-coated onto wafers at 4000 rpm, prebaked at 80°C for one minute, then exposed to 20 keV using a Cambridge electron beam exposure tool. The exposed resist was post-baked for one minute at 115°C and developed at a rate of 300Å/ second for 4 minutes using tetramethylammonium hydroxide developer to produce an image. This experiment demonstrates the use of purified hexamethoxymethylmelamine in an E-beam resist.

### Example 7 - Distilled Hexamethoxymethylmelamine in X-ray Resist

A resist was prepared by mixing 66 grams of meta-cresol novolac resin, 15.2 grams of tris(dibromopropyl)isocyanurate, 9.9 grams of distilled hexamethoxymethylmelamine (99% monomer), and 75 grams of Thinner A (Shipley Company). The resist was spin-coated onto wafers at 3500 rpm, prebaked at 80°C for one minute, then exposed using a palladium point source X-ray exposure tool. The exposed resist was post-baked for one minute at 115°C and developed at a rate of 500Å/ second for 8 minutes using tetramethylammonium hydroxide developer to produce an image. This experiment demonstrates the use of purified hexamethoxymethylmelamine in an X-ray resist.

## Claims

1. An improved photoresist, which comprises:-
(i) acid-hardening resin system comprising:
(a) melamine resin having a hexamethoxymethylmelamine monomer content of greater than 83 percent by weight, based on the weight of the melamine resin; and
(b) reactive hydrogen-containing compound; and
(ii) photoacid generator.

2. A photoresist as claimed in claim 1, wherein synthesis by-products and impurities in the melamine resin that promote self-condensation of the hexamethoxymethylmelamine monomer have been removed to an extent sufficient to reduce the degree of oligomerization during storage of the liquid resist.

3. A photoresist as claimed in claim 2, wherein water has been removed, from the melamine resin, to a level of less that 25,000 ppm, based on the photoresist.

4. A photoresist as claimed in any preceding Claim, wherein the hexamethoxymethylmelamine content of the melamine resin is greater than 87 percent by weight, based on the weight of the melamine resin.

5. A photoresist as claimed in claim 4, wherein the hexamethoxymethylmelamine content of the melamine resin is greater that 89 percent by weight, based on the weight of the melamine resin.

6. A photoresist as claimed in any preceding claim, wherein the melamine resin is distilled hexamethoxymethylmelamine.

7. A photoresist as claimed in any preceding claim, wherein the reactive hydrogen-containing compound is selected from novolac resins; polyvinylphenols; copolymers of these with styrene, α-methylstyrene, acrylic resins; polyglutarimides;polyacrylic acid and polymethacrylic acid copolymers; alkali-soluble polyacrylamides and polymethacrylamide copolymers; copolymers containing 2-hydroxyethyl(meth)acrylate and/or 2-hydroxypropyl(meth)acrylate; polyvinyl alcohols; alkali-soluble styrene-allyl alcohol copolymers; and mixtures thereof.

8. A photoresist claimed in any preceding claim, wherein the photoacid generator is selected from 1,1-bis[p-chlorophenyl]-2,2,2-trichloroethane, 1,1-bis[p-methoxyphenyl]-2,2,2-trichloroethane, 1,2,5,6,9,10-hexabromocyclododecane, 1,10-dibromodecane, 1,1-bis[p-chlorophenyl]-2,2-dichloroethane, 4,4'-dichloro-2-(trichloromethyl)benzhydrol, 1,1-bis(chlorophenyl)-2,2,2-trichloroethanol, hexachlorodimethylsulfone, 2-chloro-6-(trichloromethyl)pyridine, 0,0-diethyl-0-(3,5,6-trichloro-2-pyridyl)phosphorothioate, 1,2,3,4,5,6-hexachlorocyclohexane, N(1,1-bis[p-chlorophenyl]-2,2,2-trichloroethylacetamide, tris[2,3-dibromopropyl]isocyanurate, and 2,2-bis [p-chlorophenyl]-1,1-dichloroethylene.

9. A photoresist as claimed in any preceding claim, which comprises solvent selected from glycol ethers, aromatic hydrocarbons, ketones, esters, amides, chlorinated hydrocarbons, nitrobenzene, dimethylsulfoxide, and mixtures thereof.

## Patentansprüche

1. Verbesserter Fotoresist, der
(i) ein sauer härtendes Harzsystem, enthaltend
(a) ein Melaminharz mit einem Hexamethoxymethylmelaminmonomergehalt von größer als 83 Gew.-%, basierend auf dem Melaminharzgewicht, und
(b) eine Verbindung mit reaktivem Wasserstoff; und
(ii) einen Foto-Säuregenerator
umfaßt.

2. Fotoresist nach Anspruch 1, bei dem in dem Melaminharz Synthesenebenprodukte und Verunreinigungen, die die Selbstkondensation der Hexamethoxymethylmelaminmonomere fördern, in einem Ausmaß entfernt worden sind, das den Oligomerisierungsgrad während der Lagerung des Flüssigresists ausreichend reduziert.

3. Fotoresist nach Anspruch 2, bei dem Wasser bis zu einem Ausmaß von weniger als 25000 ppm, basierend auf dem Fotoresist, aus dem Melaminharz entfernt wurde.

4. Fotoresist nach irgendeinem der vorhergehenden Ansprüche, bei dem der Hexamethoxymethylmelamingehalt des Melaminharzes größer als 87 Gew.-% ist, basierend auf dem Melaminharzgewicht.

5. Fotoresist nach Anspruch 4, bei dem der Hexamethoxymelamingehalt des Melaminharzes größer als 89 Gew.-% ist, basierend auf dem Melaminharzgewicht.

6. Fotoresist nach irgendeinem der vorhergehenden Ansprüche, bei dem das Melaminharz destilliertes Hexamethoxymethylmelamin ist.

7. Fotoresist nach irgendeinem der vorhergehenden Ansprüche, bei dem die reaktiven Wasserstoff enthaltende Verbindung ausgewählt ist aus Novolakharzen; Polyvinylphenolen; deren Copolymeren mit Styrol, α-Methylstyrol, Acrylharzen; Polyglutarimiden; Polyacrylsäure- und Polymethacrylsäure-Copolymeren; alkalilöslische Polyacrylamid- und Polymethacrylamid-Copolymeren; Copolymeren, die 2-Hydroxyethyl(meth)acrylate und/oder 2-Hydroxypropyl(meth)acrylate enthalten; Polyvinylalkoholen; alkalilöslische Styrol-Allylalkohol-Copolymeren und Mischungen davon.

8. Fotoresist nach irgendeinem der vorhergehenden Ansprüche, bei dem der Foto-Säuregenerator ausgewählt ist aus 1,1-Bis[p-chlorphenyl]-2,2,2-trichlorethan, 1,1-Bis[p-methoxyphenyl]-2,2,2-trichlorethan, 1,2,5,6,9,10-Hexabromcyclododecan, 1,10-Dibromdecan, 1,1-Bis[p-chlorphenyl]-2,2-dichlorethan, 4,4'-Dichlor-2-(trichlormethyl)benzhydrol, 1,1-Bis(chlorphenyl)-2,2,2-trichlorethanol, Hexachlordimethylsulfon, 2-Chlor-6-(trichlormethyl)pyridin, O,O-Diethyl-O-(3,5,6-trichlor-2-pyridyl)phosphorthioat, 1,2,3,4,5,6-Hexachlorcyclohexan, N(1,1-Bis[p-chlorphenyl]-2,2,2-trichlorethylacetamid, Tris[2,3-dibrompropyl]isocyanurat und 2,2-Bis[p-Chlorphenyl]-1,1-dichlorethylen.

9. Fotoresist nach irgendeinem der vorhergehenden Ansprüche, der ein Lösungsmittel umfaßt, ausgewählt aus Glykolethern, aromatischen Kohlenwasserstoffen, Ketonen, Estern, Amiden, chlorierten Kohlenwasserstoffen, Nitrobenzol, Dimethylsulfoxid und Mischungen davon.

## Revendications

1. Photorésist perfectionné, qui comprend:
(i) un système de résine durcissant aux acides, comprenant:
(a) une résine mélamine ayant une teneur en monomère d'hexaméthoxyméthylmélamine supérieure à 83% en poids, sur la base du poids de la résine mélamine; et
(b) un composé contenant de l'hydrogène réactif; et
(ii) un générateur de photoacide.

2. Photorésist selon la revendication 1, dans lequel les sous-produits de synthèse et les impuretés dans la résine mélamine qui favorisent l'autocondensation du monomère d'hexaméthoxyméthylmélamine ont été éliminés dans une mesure suffisante pour réduire le degré d'oligomérisation au cours de la conservation du résist liquide.

3. Photorésist selon la revendication 2, dans lequel de l'eau a été retirée, à partir de la résine mélamine, jusqu'à un niveau inférieur à 25 000 ppm, sur la base du photorésist.

4. Photorésist selon l'une quelconque des revendications précédentes, dans lequel la teneur en hexaméthoxyméthylmélamine de la résine mélamine est supérieure à 87% en poids, sur la base du poids de la résine mélamine.

5. Photorésist selon la revendication 4, dans lequel la teneur en hexaméthoxyméthylmélamine de la résine mélamine est supérieure à 89% en poids, sur la base du poids de la résine mélamine.

6. Photorésist selon l'une quelconque des revendications précédentes, dans lequel la résine mélamine est l'hexaméthoxyméthylmélamine distillée.

7. Photorésist selon l'une quelconque des revendications précédentes, dans lequel le composé contenant de l'hydrogène réactif est choisi parmi les résines novolaques; les polyvinylphénols, les copolymères de ceux-ci avec le styrène, l'α-méthylstyrène, les résines acryliques; les polyglutarimides; les copolymères d'acide polyacrylique et d'acide polyméthacrylique; les copolymères de polyacrylamide et de polyméthacrylamide solubles dans les bases; les copolymères contenant du (méth)acrylate de 2-hydroxyéthyle et/ou du (méth)acrylate de 2-hydroxypropyle; les alcools polyvinyliques; les copolymères styrène-alcool allylique solubles dans les bases; et leurs mélanges.

8. Photorésist selon l'une quelconque des revendications précédentes, dans lequel le générateur de photoacide est choisi parmi le 1,1-bis[p-chlorophényl]-2,2,2-trichloroéthane, le 1,1-bis[p-méthoxyphényl]-2,2,2-trichloroéthane, le 1,2,5,6,9,10-hexabromocyclododécane, le 1,10-dibromodécane, le 1,1-bis[p-chlorophényl]-2,2-dichloroéthane, le 4,4'-dichloro-2-(trichlorométhyl)benzhydrol, le 1,1-bis(chlorophényl)-2,2,2-trichloroéthanol, l'hexachlorodiméthylsulfone, la 2-chloro-6-(trichlorométhyl)-pyridine, le 0,0-diéthyl-0-(3,5,6-trichloro-2-pyridyl)phosphorothioate, le 1,2,3,4,5,6-hexachlorocyclohexane, le N(1,1-bis[p-chlorophényl]-2,2,2-trichloroéthylacétamide, le tris[2,3-dibromopropyl]-isocyanurate et le 2,2-bis[p-chlorophényl]-1,1-dichloroéthylène.

9. Photorésist selon l'une quelconque des revendications précédentes, qui comprend un solvant choisi parmi les éthers de glycol, les hydrocarbures aromatiques, les cétones, les esters, les amides, les hydrocarbures chlorés, le nitrobenzène, le diméthylsulfoxyde et leurs mélanges.
